# FASCICULE DE BREVET EUROPEEN

(11) **EP 0 359 679 B1**
(45) Date de publication et mention de la délivrance du brevet: **16.02.1994**
(21) Numéro de dépôt: 89420327.2
(22) Date de dépôt: 06.09.1989
(51) Int. Cl.: H01L 21/329, H01L 29/90

(54) **Procédé de fabrication d'une diode de régulation et de protection**
Verfahren zum Herstellen einer Regelungs- und Schutzdiode
Method of producing a diode for control and protection

(30) Priorité: 09.09.1988 FR 8812346
(43) Date de publication de la demande: 21.03.1990
(73) Titulaire: SGS-THOMSON MICROELECTRONICS S.A., 94250 Gentilly (FR)
(72) Inventeur: Ducreux, Gérard, 37230 Luynes (FR)
(74) Mandataire: de Beaumont, Michel

(56) Documents cités:
- DE-A- 3 151 437
- GB-A- 2 130 792
- US-A- 4 177 095

## Description

La présente invention concerne le domaine des diodes de régulation, et plus particulièrement de telles diodes pouvant assurer une fonction de régulation et une fonction de protection.

Une diode de régulation est une diode destinée à fonctionner dans un domaine de faible puissance, par exemple du watt, avec des courants de quelques milliampères et des tensions de claquage déterminées dans une plage allant couramment de 2 à 200 volts. Une telle diode, polarisée en inverse, débite en régime d'avalanche (effet zener ou effet d'avalanche selon la tension) avec une résistance dynamique aussi faible que possible, c'est-à-dire que la caractéristique courant-tension de cette diode doit présenter un coude marqué et que la tension doit rester ensuite sensiblement constante quand le courant augmente.

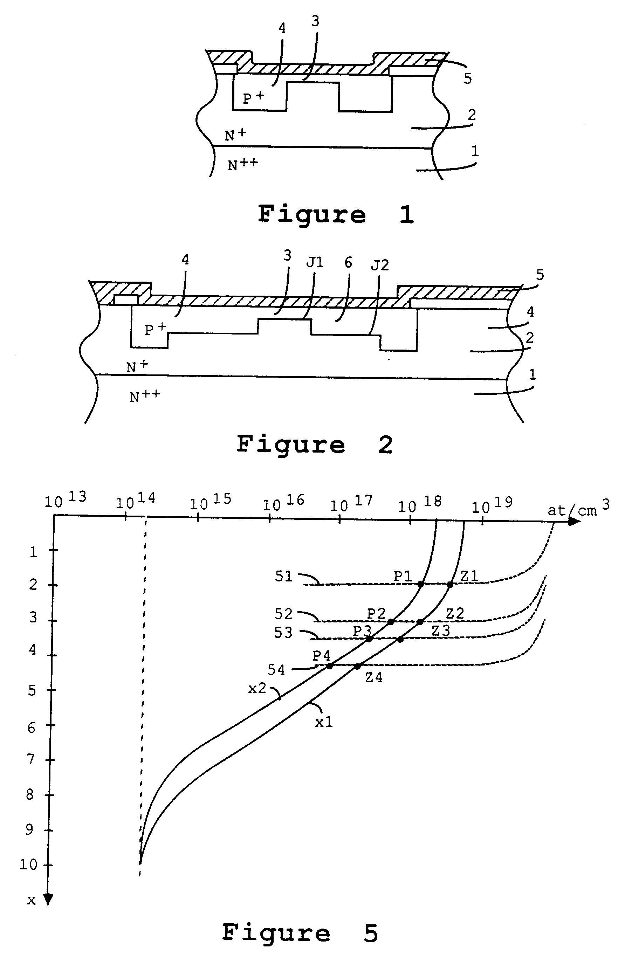

Un exemple de diode de régulation classique est représenté en figure 1. Cette diode est formée sur un substrat comprenant une couche 1 de type N fortement dopée (N++) sur laquelle est formée une couche 2 de type N encore fortement dopée (N+), d'un niveau de dopage choisi en fonction de la tension de régulation visée. A partir de la surface supérieure de ce substrat est formée une couche 3 de type P. La surface de la fenêtre à partir de laquelle est formée la couche 3 est réduite et calibrée en fonction de la densité de courant à obtenir lors du fonctionnement en régulation. Couramment, la jonction entre la couche 3 et la couche 2 est entourée d'un anneau de garde 4 constitué d'une région de même type de conductivité que la couche 3 mais de plus faible dopage à l'interface entre cette couche et la région N+. Cet anneau de garde est, comme cela est connu, notamment destiné à assurer le bon fonctionnement du phénomène zener ou d'avalanche recherché en évitant les problèmes liés à la courbure de jonction à la périphérie. Ensuite, la face supérieure de la diode est revêtue d'une métallisation 5 de même que la face inférieure (non représentée).

Dans une telle diode zener, la tension d'avalanche ou tension de régulation est déterminée essentiellement par le niveau de dopage de la couche 2 de type N+ et seulement au deuxième ordre par le gradient de la jonction PN et la forme particulière de cette jonction (jonction plane ou arrondie). Ainsi, quand on veut réaliser des diodes de régulation correspondant à des tensions différentes, on choisit des couches 2 de dopages de niveaux différents. Par exemple, pour une tension de régulation de 3 volts, la résistivité de la couche 2 de type N+ sera de l'ordre de 6 mohms.cm (environ 10¹⁹ atomes/cm³) ; pour une tension de régulation de 51 volts, cette résistivité sera de 300 mohms.cm ; et pour une tension de régulation de 200 volts, cette valeur sera de 2,5 ohms.cm (environ 2x10¹⁵ atomes/cm³).

D'autre part, une structure de diode zener telle qu'illustrée en figure 1 est fragile lorsque des impulsions de courant de plusieurs ampères sont appliquées car la densité de courant dans la zone active (interface entre les couches 3 et 2) devient trop importante et l'échauffement devient élevé.

Par ailleurs, on fabrique également des diodes dites de protection par écrétage dont l'objet es d'encaisser des surintensités ou surtensions instantanées très élevées en supportant des surcharges de courant de plusieurs ampères en inverse. Dans ce but, il est souhaitable de favoriser la dispersion thermique en répartissant l'échauffement sur la surface la plus grande possible. On a donc là, contrairement au cas des diodes de régulation, des jonctions de grandes surfaces.

On a proposé dans la technique de combiner les fonctions de régulation et de protection en associant une diode de régulation de faible surface et une diode de protection de plus grande surface fonctionnant à un seuil légèrement plus élevé que celui de la diode de régulation, pour prendre le relais quand une surintensité est appliquée.

Un exemple d'une telle diode classique est illustré en figure 2. Dans cette figure, de mêmes références désignent de mêmes éléments qu'en figure 1. En plus des jonctions déjà représentées en figure 1, il est prévu une zone 6 de type P de surface relativement importante entourant la zone de diode de régulation 3 et située entre cette diode et l'anneau de garde 4 (dans certaines réalisations, il n'est pas prévu d'anneau de garde). On appelera J1 la jonction de régulation entre la zone diffusée 3 et la couche 2 de type N+ et J2 la jonction de protection entre la zone diffusée 6 et cette couche 2.

La réalisation d'une telle structure pose de nombreux problèmes technologiques car elle exige d'ajuster de façon reproductible les tensions d'avalanche V1 et V2 associées aux deux jonctions J1 et J2. En fait, il faut ajuster soigneusement la tension V1 correspondant à la jonction J1 pour déterminer la tension de régulation visée. Puis, pour avoir une performance de protection satisfaisante, il faut ajuster de façon prédéterminée l'écart de tension V2 - V1 qui détermine la performance de la protection.

Classiquement, une structure telle que celle de la figure 2 est réalisée à partir d'un substrat de type N+ correspondant au niveau de dopage choisi pour la couche 2 et la face arrière est plus fortement dopée pour former la couche 1 de type N++ destinée à réduire la résistivité de la diode et à améliorer la prise de contact ohmique sur sa face arrière. Ensuite, les jonctions J1 et J2 sont formées par exemple en diffusant d'abord l'anneau de protection 6 à partir d'une source solide de dopant. La tension de l'anneau de protection est déterminée au premier ordre par la durée de recuit. Une diffusion de la jonction centrale 3 est ensuite effectuée à partir également d'une source solide.

On n'a pas décrit dans ce qui précède la réalisation de l'anneau de garde qui sera effectuée de façon classique.

Bien entendu, selon les technologies, d'autres procédés de diffusion que celui résultant d'une diffusion d'une source solide de dopants peuvent être utilisés, par exemple des diffusions en phase gazeuse, ou des implantations suivies de recuits.

Ces technologies présentent divers inconvénients et limitations parmi lesquels on peut citer les suivants.
1) Etant donné que c'est le niveau de dopage de la couche 2 de type N qui détermine au premier ordre la tension de régulation, le fabricant qui veut fournir toute une gamme de diodes correspondant à des tensions de régulation différentes devra s'approvisionner en silicium dans toute une gamme de résistivités, chacune correspondant à une tension de régulation visée ; il en résulte des problèmes de stock importants.
2) Sur une plaquette de silicium donné, il existe une dispersion de résistivité qui peut être de l'ordre de 20 % (striation des lingots) et qui peut induire une dispersion des tensions de régulation de l'ordre de 10 %. Il en résulte, à la suite du tri effectué par le fabricant, une perte de rendement de fabrication.
3) Etant donné le choix de la tension de régulation, pour déterminer la tension de protection, on doit choisir la durée de diffusion de la couche de type P correspondante (couche 6). Ceci est effectué de façon empirique en élaborant au préalable un tableau de durées de diffusion, à chaque durée correspondant une tension de protection. Ce procédé rend très difficile de choisir un écart bien déterminé entre la tension de protection et la tension de régulation. En d'autres termes, pour chaque choix de résistivité de la couche 2, il faut choisir les durées de diffusion des zones correspondant à la jonction de régulation et à la jonction de protection ce qui est une opération technologiquement complexe.

Ainsi, un objet de la présente invention est de prévoir un procédé de fabrication de diodes de régulation et de protection permettant d'éviter les inconvénients susmentionnés, et permettant notamment :
- de s'approvisionner de façon unique en substrats,
- de s'affranchir des éventuelles dispersions de résistivité du substrat,
- d'obtenir un écart prédéterminé entre les tensions de régulation et de protection.

Pour atteindre ces objets ainsi que d'autres, la présente invention prévoit un procédé de fabrication d'une diode de régulation et de protection sur un substrat comprenant une première couche épaisse de type N fortement dopée et une deuxième couche de type N faiblement dopée sur ladite première couche, comprenant les étapes consistant à : implanter dans une première zone de petite surface des dopants de type N dans la deuxième couche, réaliser un premier recuit, implanter dans une deuxième zone englobant et entourant la première zone des dopants de type N, réaliser un deuxième recuit, implanter dans une troisième zone englobant la première zone et au moins une partie de la deuxième zone un dopant de type P, réaliser un troisième recuit, et former des électrodes sur une partie de la troisième zone et sur la face opposée du substrat.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1 et 2 illustrent respectivement une diode de régulation et une diode de régulation et de protection classiques et ont été décrites précédemment ;
les figures 3A à 3F illustrent des étapes successives de fabrication d'une diode de protection et de régulation selon la présente invention ;
la figure 4 représente une variante de diode de régulation et de protection selon la présente invention ; et
les figures 5 et 6 représentent des courbes de concentration de dopants en atomes/cm³ en fonction de la profondeur de pénétration, x, en micromètres.

Dans ces diverses figures, on notera que les épaisseurs et dimensions latérales des couches ne sont pas représentées à l'échelle mais, comme cela est classique dans le domaine de la représentation des structures semiconductrices, que les diverses dimensions sont choisies arbitrairement pour faciliter la lisibilité des figures. De même, dans la représentation des diverses diffusions, on n'a pas tenu compte des diffusions latérales et les coins sont représentés comme des angles droits alors qu'ils sont normalement plus ou moins arrondis, comme cela apparaîtra clairement à l'homme de l'art.

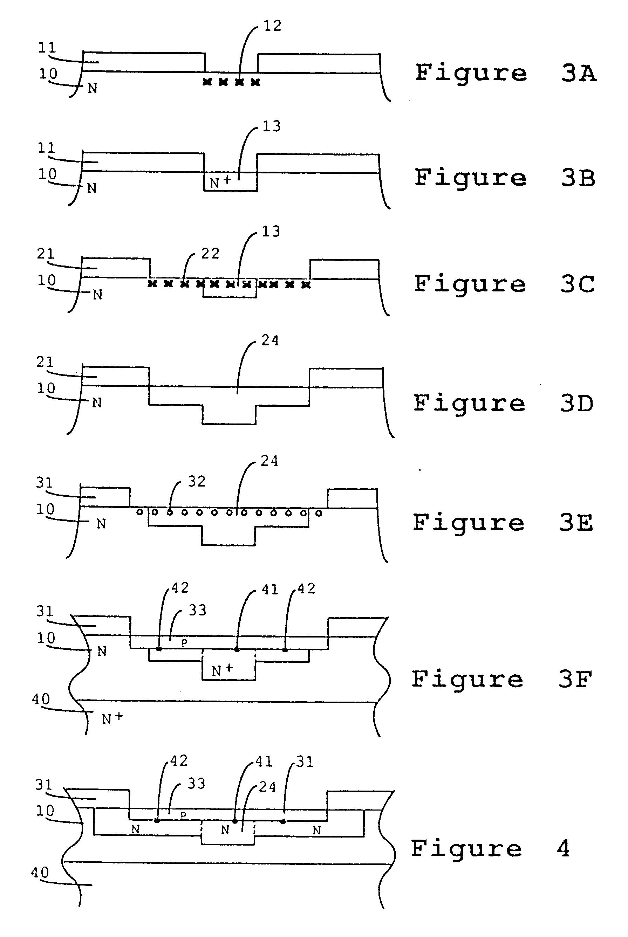

La figure 3A illustre une première étape de fabrication d'une diode de régulation et de protection selon l'invention. Cette diode est élaborée sur une couche 10 de type N, faiblement dopée, elle-même formée sur un substrat de même type de conductivité mais à plus fort niveau de dopage comme cela apparaîtra dans la figure 3F. Une fenêtre est ouverte dans une couche de masquage 11 et une implantation 12 de type N est formée dans la couche 10. La fenêtre correspond à la surface de la jonction de régulation que l'on veut former.

Dans une deuxième étape, illustrée en figure 3B, il est procédé à un recuit, d'où il résulte qu'une zone 13 de type N+ est formée dans la couche 10.

A la figure 3C, est représentée une deuxième couche de masquage 21 dans laquelle est formée une fenêtre dont la dimension correspond à la surface de la diode de protection que l'on veut réaliser. Une implantation 22 délimitée par cette fenêtre est effectuée dans la couche 10 et la région 13.

La figure 3D représente la structure après un deuxième recuit. Ainsi, une région 24 est formée dans la fenêtre délimitée par la couche de masquage 21, cette région diffusée 24 étant plus profonde à l'emplacement ayant subi les deux implantations successives.

A l'étape illustrée en figure 3E, un nouveau masque 31 est formé pour délimiter une implantation 32 de dopants de type P suffisamment concentrés pour inverser le type de conductivité dans toutes les régions où cette implantation est formée, c'est-à-dire aussi bien dans le substrat 10 que dans la région 24.

Ensuite, un recuit est effectué pour fournir la structure illustrée en figure 3F. Dans cette figure 3F, on a montré que la couche 10 est formée à la surface d'un substrat 40 de type N+, cette couche 10 résultant par exemple d'une épitaxie.

La figure 4 représente une variante de réalisation de la diode de régulation et de protection de la figure 3F. Dans cette réalisation, le masque correspondant à la deuxième implantation (de type N) est plus grand que le masque correspondant à la troisième implantation (de type P). L'homme de l'art pourra, selon les résultats qu'il cherche à obtenir, choisir l'une ou l'autre de ces structures.

Dans les structures selon l'invention (figures 3 et 4), la couche 33 de type P résultant de l'implantation 32 forme donc une première jonction J1 dans une zone 41 avec la région de type N résultant d'une double implantation, jonction qui correspond à la diode de régulation et une deuxième jonction J2 dans une zone 42 avec la région de type N ayant subi une seule implantation, jonction qui correspond à la diode de protection.

Ainsi, les tensions de régulation et de protection dépendront des implantations successives réalisées et non pas (ou très peu) du niveau de dopage de la couche 10 initiale et des éventuelles dispersions de résistivité de cette couche.

La présente invention résoud donc bien les deux premiers inconvénients mentionnés ci-dessus des structures de l'art antérieur (nécessité de prévoir des substrats multiples et problèmes liés à la dispersion des substrats).

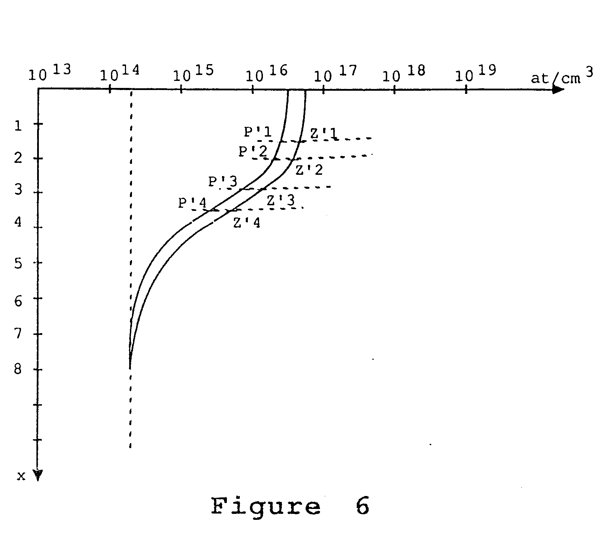

On va maintenant montrer en relation avec les figures 5 et 6 comment le troisième inconvénient de l'art antérieur (difficulté de fixer un écart précis et constant entre les tensions de régulation et de protection) est résolu par la présente invention.

La figure 5 représente des courbes indiquant la concentration des porteurs introduits dans la couche 10 en fonction de la profondeur, x, dans cette couche mesurée à partir de la surface. Dans le cadre de cet exemple, on considère une couche 10 en silicium d'orientation cristallographique (111) et dopée de type N au phosphore avec une concentration de 2x10¹⁴ atomes/cm³. Les implantations de type N sont deux implantations identiques réalisées sous une énergie de 80 keV et une densité de 6x10¹⁴ atomes/cm². Après la première implantation, on a procédé à un recuit d'une heure à 1180°C et, après la deuxième implantation, à un recuit de 4 heures à 1180°C. On obtient ainsi des profils de diffusion tels qu'indiqués par les courbes x₁ et x₂ qui correspondent respectivement à la région de diode de régulation (ou diode zener) et à la région de diode de protection.

Une caractéristique importante de ces courbes x₁ et x₂ est qu'elles sont sensiblement parallèles l'une à l'autre dans une zone importante.

D'autre part, dans cette figure 5, les courbes en pointillés 51 à 54 correspondent à la profondeur de pénétration de la couche 33 de type P en fonction du niveau de dopage N sous-jacent, pour diverses valeurs de durée de recuit. Ainsi, la courbe 51 correspond au cas où une implantation de type P+ (par exemple des atomes de bore) a été suivie d'un recuit d'une heure à 1050°C, la courbe 52 au cas où le recuit a duré trois heures à 1050°C, la courbe 53 au cas où le recuit a duré cinq heures à 1050°C, et la courbe 54 au cas où le recuit a duré une heure à 1150°C (le recuit de diffusion des dopants de type P étant effectué à une température nettement inférieure à celle des premiers recuits de diffusion des dopants de type N, il n'a que peu d'influence sur la redistribution des dopants de type N).

On désigne par Z1, P1 les intersections des courbes x₁ et x₂ avec la courbe 51 ... et par Z4, P4 les intersections des courbes x₁ et x₂ avec la courbe 54. Ces points d'intersection indiquent la concentration en dopants de type N aux jonctions d'où on peut déduire les tensions de régulation et de protection.

Le tableau 1 ci-dessous indique les valeurs des tensions d'avalanche correspondant à chacun de ces points Z1 à Z4 et P1 à P4, et la valeur en % entre parenthèses indique l'écart entre ces tensions pour des points homologues.

**TABLEAU 1**

| | | |
|---|---|---|
| Z1 : 7,5 V | P1 : 9 V | (20 %) |
| Z2 : 9 V | P2 : 10,7 V | (18 %) |
| Z3 : 10 V | P3 : 11,8 V | (18 %) |
| Z4 : 11,5 V | P4 : 17 V | (40 %) |

On voit que, pour les intersections avec les courbes 51 à 53, on a un écart en pourcentage sensiblement constant entre les tensions d'avalanche des jonctions de régulation et de protection, ce qui est le but recherché. On peut donc, pour des implantations de type N et des recuits déterminés, et en fonction de la durée de diffusion de l'implantation de type P, construire une série de diodes correspondant à des valeurs de tensions de régulation choisies, la tension de protection étant adaptée automatiquement à cette valeur de régulation. Si la tension de régulation d'un lot de diodes s'avère être inférieur à la valeur recherchée, on pourra procéder à un recuit supplémentaire pour augmenter la tension de régulation sans affecter la relation entre la tension de régulation et la tension de protection.

La figure 6 représente des courbes analogues à celles de la figure 5 pour un autre choix des implantations de type N+ et des recuits correspondants. Dans le cas de la figure 6, on part du même substrat qu'en figure 5. Les implantations de phosphore sont réalisées sous 80 keV avec une densité de 6x10¹² atomes/cm². Les durées de recuit sont identiques (1 heure et 4 heures). Le tableau 2 ci-dessous indique, de façon similaire au tableau 1 présenté en relation avec la figure 5, que l'on peut atteindre des tensions d'avalanche de la diode de régulation comprises entre 30 et 73 volts avec des tensions d'avalanche de la diode de protection différant d'environ 30 % de ces valeurs.

**TABLEAU 2**

| | | |
|---|---|---|
| Z'1 : 30 V | P'1 : 38 V | (27 %) |
| Z'2 : 36 V | P'2 : 48 V | (33 %) |
| Z'3 : 47 V | P'3 : 63 V | (34 %) |
| Z'4 : 73 V | P'4 : 100 V | (37 %) |

Ainsi, il a été déterminé que, pour obtenir des tensions de régulation comprises entre 7,5 et 75 V, il suffit de cinq choix d'implantation initiaux. De 7 à 9 V, on pourra choisir des doses d'implantation de 6x10¹⁴ at./cm², de 9 à 14 V de 10¹⁴ at./cm², de 14 à 18 V de 6x10¹³ at./cm², de 19 à 28 V de 2x10¹³ at./cm² et de 28 à 75 V de 6x10¹² at./cm², toutes les autres conditions étant celles indiquées dans les exemples précédents.

Bien entendu, la présente invention est susceptible de nombreuses variantes qui apparaîtront à l'homme de l'art. Notamment les perfectionnements classiques aux diodes de régulation et de protection pourront être apportés : modes d'implantation et de recuit, isolement latéral ou anneaux de garde, modes de prise de contacts...

## Revendications

1. Procédé de fabrication d'une diode de régulation et de protection sur un substrat comprenant une première couche épaisse (40) de type N fortement dopée et une deuxième couche (10) de type N faiblement dopée sur ladite première couche (40), caractérisé en ce qu'il comprend les étapes successives suivantes :
implanter dans une première zone de petite surface des dopants (12) de type N dans la deuxième couche,
réaliser un premier recuit,
implanter dans une deuxième zone englobant et entourant la première zone des dopants (22) de type N,
réaliser un deuxième recuit,
implanter dans une troisième zone englobant la première zone et au moins une partie de la deuxième zone des dopants (32) de type P,
réaliser un troisième recuit, et
former des électrodes sur une partie de la troisième zone et sur la face opposée du substrat.

2. Procédé de fabrication d'une diode de régulation et de protection selon la revendication 1, caractérisé en ce qu'il comprend en outre une étape de réglage de la tension de régulation comprenant les étapes consistant à :
- mesurer la tension de régulation, et
- prolonger le troisième recuit si cette tension de régulation est plus faible que la valeur visée, la tension de régulation étant ainsi augmentée et l'écart entre tension de régulation et tension de protection restant constant.

3. Procédé de fabrication d'une diode de régulation et de protection selon l'une des revendications 1 ou 2, caractérisé en ce que les première et deuxième étapes d'implantation de type N sont réalisées avec de mêmes doses d'implantation.

## Claims

1. A process for the manufacturing of a regulation and protection diode on a substrate comprising a first thick and highly doped N-type layer (40) and a second low doped N-type layer (10) on said first layer, characterized in that it comprises the following successive steps:
- implanting in a first small surface area N-type dopants (12) in the second layer,
- carrying out a first annealing process,
- implanting in a second area including and surrounding the first area N-type dopants (22),
- carrying out a second annealing process,
- implanting in a third area including the first area and at least one portion of the second area P-type dopants (32),
- carrying out a third annealing process, and
- forming electrodes on a portion of the third area and on the opposite surface of the substrate.

2. A process for manufacturing a regulation and protection diode according to claim 1, characterized in that it further comprises a regulation voltage setting step comprising the steps consisting in:
- measuring the regulation voltage, and
- continuing the third annealing process if said regulation voltage is lower than the desired value, the regulation voltage being accordingly increased, and the difference between the regulation voltage and the protection voltage remaining constant.

3. A process for manufacturing a regulation and protection diode according to claim 1 or 2, characterized in that the first and second N-type implantation steps are carried out with the same implantation doses.

## Patentansprüche

1. Verfahren zum Herstellen einer Regel- und Schutzdiode auf einem Substrat mit einer ersten dicken, hoch dotierten N-Schicht (40) und einer zweiten, niedrig dotierten N-Schicht (10) auf dieser ersten Schicht (40),
gekennzeichnet durch die folgenden aufeinanderfolgenden Schritte:
Implantieren von Dotierungsstoffen (12) vom N-Typ in einem ersten kleinen Oberflächenbereich in der zweiten Schicht,
Ausführen eines ersten Tempervorgangs,
Implantieren von Dotierungsstoffen (22) vom N-Typ in einem zweiten Bereich, der den ersten Bereich einschließt und umgibt,
Ausführen eines zweiten Tempervorgangs,
Implantieren von Dotierungsstoffen (32) vom P-Typ in einem dritten Bereich, der den ersten Bereich und zumindest einen Teil des zweiten Bereiches einschließt,
Ausführen eines dritten Tempervorgangs und
Ausbilden von Elektroden auf einem Teil des dritten Bereiches und auf der gegenüberliegenden Seite des Substrates.

2. Verfahren zum Herstellen einer Regel- und Schutzdiode nach Anspruch 1, dadurch gekennzeichnet, daß das Verfahren zudem einen Schritt zum Einstellen der Regelspannung mit folgenden Schritten aufweist:
- Messen der Regelspannung und
- Verlängern des dritten Tempervorgangs, wenn diese Regelspannung niedriger als der gewünschte Wert ist, wobei die Regelspannung entsprechend erhöht wird und die Differenz zwischen der Regelspannung und der Schutzspannung konstant bleibt.

3. Verfahren zum Herstellen einer Regel- und Schutzdiode nach einem der Ansprüche 1 oder 2, dadurch gekennzeichnet, daß die ersten und zweiten Schritte der Implantation mit N-Typ-Stoffen mit der gleichen Implantationsdosis ausgeführt werden.
